# EUROPÄISCHE PATENTSCHRIFT

(11) **EP 3 652 860 B1**
(45) Veröffentlichungstag und Bekanntmachung des Hinweises auf die Patenterteilung: **27.12.2023**
(21) Anmeldenummer: 18739455.6
(22) Anmeldetag: 12.06.2018
(51) Int. Cl.: H03K 19/082, H03K 19/094, H03K 19/0175, H03K 5/003, H03K 19/0185

(54) **PEGELWANDLER UND EIN VERFAHREN ZUM WANDELN VON PEGELWERTEN IN FAHRZEUGSTEUERGERÄTEN**
LEVEL CONVERTER AND A METHOD FOR CONVERTING LEVEL VALUES IN VEHICLE CONTROL DEVICES
CONVERTISSEUR DE NIVEAU ET PROCÉDÉ DE CONVERSION DE VALEURS DE NIVEAU DANS DES DISPOSITIFS DE COMMANDE DE VÉHICULE

(30) Priorität: 11.07.2017 DE 102017115511
(43) Veröffentlichungstag der Anmeldung: 20.05.2020
(73) Patentinhaber: KNORR-BREMSE Systeme für Nutzfahrzeuge GmbH, 80809 München (DE)
(72) Erfinder: FEUCHT, Thomas, 71299 Wimsheim (DE)
(86) Internationale Anmeldenummer: PCT/EP2018/065556
(87) Internationale Veröffentlichungsnummer: WO 2019/011556

(56) Entgegenhaltungen:
- DE-A1- 2 363 735
- JP-A- S57 147 330
- US-A- 5 633 603
- US-B1- 6 815 984

## Beschreibung

Die vorliegende Erfindung bezieht sich auf einen Pegelwandler für ein Fahrzeugsteuergerät und ein Verfahren zum Wandeln von Pegelwerten in Fahrzeugsteuergeräten und insbesondere auf einen Tristate-Pegelwandler (mit 3 Zuständen) in sicherheitskritischen Systemen.

In der Automobiltechnik und insbesondere bei sicherheitskritischen Systemen ist es häufig erforderlich, Pegelwerte auf mehrere einstellbare Niveaus oder Zustände zu setzen. Zum Beispiel sind das Spannungswerte von 0 V oder 5 V oder auch ein hochohmiger Zustand. Die sicherheitsrelevanten Systeme umfassen beispielsweise: ABS (ABS = Antiblockiersystem), EBS (EBS = elektronisches Bremssystem), ESP (ESP = elektronisches Stabilitätsprogramm) oder Getriebesteller.

Die genannte Umsetzung auf drei Zustände (sogenannte Tristate-Systeme) wird beispielsweise genutzt, um analoge Signale mit drei verschiedenen Spannungswerten zu beaufschlagen oder das analoge Signal auf ein definiertes Pegelniveau zu ziehen. Das Umschalten auf die einzelnen Spannungswerte wird mittels Signalleitungen (Rechnerports) wie beispielsweise in EBS5.x und EBS7 ausgelöst. Es ist ebenfalls möglich, eine Pegelumsetzung mit zwei Spannungspegeln mittels integrierter Schaltungen und einem Rechnerport oder mit drei Spannungspegeln mittels zwei Rechnerports zu erreichen. Ein solcher Wandler ist beispielsweise in US 5,633,603 offenbart. Weitere bekannte Wandler sind in DE 23 63 736, US 6,815,984 und JP S57 147330 offenbart, wobei auch bei diesen Wandlern zwei Ports zum Einstellen der drei Pegelzustände genutzt werden.

Es besteht jedoch ein Bedarf nach Pegelumsetzungen für drei Spannungswerte (Tristate) mittels nur einer Signalleitung. Außerdem sollen bei diesen Pegelumsetzungen vermehrt Kosten als auch Ressourcen eingespart werden.

Zumindest ein Teil der oben genannten Probleme der konventionellen Systeme werden erfindungsgemäß durch einen Pegelwandler nach Anspruch 1 und ein Verfahren zum Wandeln von Pegelwerten nach Anspruch 12 gelöst.

Die vorliegende Erfindung bezieht sich auf einen Pegelwandler für ein Fahrzeugsteuergerät. Der Pegelwandler umfasst einen ersten Spannungsanschluss einen zweiten Spannungsanschluss, einen Eingangsanschluss und zumindest einen Ausgangsanschluss. Außerdem umfasst der Pegelwandler einen ersten und einen zweiten Schalter. Der erste Schalter ist ausgebildet zum Schalten eines ersten Strompfades zwischen dem ersten Spannungsanschluss und dem zumindest einen Ausgangsanschluss (oder einem der Ausgangsanschlüsse). Der zweite Schalter ist ausgebildet zum Schalten eines zweiten Strompfades zwischen dem zweiten Spannungsanschluss und dem zumindest einen Ausgangsanschluss (oder einem anderen der Ausgangsanschlüsse). Der erste Schalter und der zweite Schalter schalten ansprechend auf verschiedene Pegelniveaus am Eingangsanschluss derart, dass: (i) bei Anliegen eines ersten Pegelniveaus an dem Eingangsanschluss der erste Schalter geschlossen ist und der zweite Schalter geöffnet ist, und (ii) bei Anliegen eines zweiten Pegelniveaus der erste Schalter geöffnet ist und der zweite Schalter geschlossen ist. Im Rahmen der vorliegenden Erfindung soll unter einem Schalter, der zwischen zwei Elementen geschaltet ist, ein elektrisches Bauelement verstanden werden, welches ansprechend auf ein Steuersignal einen Strompfad zwischen den beiden Elementen öffnet oder schließt (z.B. zwischen dem ersten/zweiten Spannungsanschluss und dem entsprechenden Ausgangsanschluss). Der erste Schalter und der zweite Schalter können komplementär ansprechend auf einen Wechsel von Pegelniveaus an dem Eingangsanschluss schalten. Das Schalten kann beispielsweise parallel erfolgen, es kann aber auch zeitlich versetzt (sequentiell) bei einem Ändern des Pegelniveaus erfolgen. Beide Schalter sollten aber nicht gleichzeitig geschlossen sein.

Der erste Schalter und der zweite Schalter sind aber ausgebildet dass beide Schalter bei Anliegen eines dritten Pegelniveaus an dem Eingangsanschluss geöffnet sind. Optional kann das dritte Pegelniveau zwischen dem ersten Pegelniveau und dem zweiten Pegelniveau liegen.

Unter einem Pegelniveau kann beispielsweise ein bestimmter Spannungswert verstanden werden. Es versteht sich aber, dass die Pegelniveaus innerhalb bestimmter Bereiche von Spannungswerten liegen können, wobei für beliebige Spannungen innerhalb der genannten Bereiche der definierte Schaltungszustand (offen oder geschlossen) eingenommen wird. Daher können die drei Pegelniveaus drei Bereiche von Spannungswerte an dem Eingangsanschluss definieren, für die die gewünschten Pegelwerte am Ausgangsanschluss erreicht werden. Bei mehreren Ausgangsanschlüssen ist zumindest einer davon stets hochohmig und die entsprechenden Pegelwerte liegen dann an dem anderen Ausgangsanschluss an (der nicht hochohmig ist). Die gewünschten Pegelwerte werden durch Spannungswerte am ersten und zweiten Spannungsanschluss erreicht. Insbesondere brauchen die drei Pegelwerte am Eingangsanschluss nicht mit den Spannungswerten an dem ersten und dem zweiten Spannungsanschluss korrelieren. Beispielsweise kann am Eingangsanschluss ein LOW (HIGH) Pegelniveau zu einem HIGH (LOW) Pegelniveau am Ausgangsanschluss führen.

Erfindungsgemäß ist eine Ansteuerschaltung vorgesehen, die die Schaltoperationen bewirken. Die Schalter selbst als auch die Ansteuerschaltung kann verschiedene Bauelemente (z.B. einen oder mehrere Transistoren) aufweisen, so dass sich die einzelnen Schaltoperationen im Prinzip beliebig konfigurieren lassen. Daher kann auch ein LOW (HIGH) Pegelniveau ein Eingangsanschluss zu einem LOW (HIGH) Pegelniveau am Ausgangsanschluss führen.

Der erste Schalter und der zweite Schalter weisen jeweils einen Steueranschluss auf, um ansprechend auf Steuersignale jeweils den ersten Schalter und den zweiten Schalter zu schalten. Erfindungsgemäß umfasst der Pegelwandler eine Ansteuerschaltung mit einer Referenzspannungseinheit zum Ansteuern der Steueranschlüsse des ersten Schalters und des zweiten Schalters. Die Referenzspannungseinheit ist beispielsweise ausgebildet, um das dritte Pegelniveau bereitzustellen, sodass bei einem hochohmig geschalteten Eingangsanschluss der erste Schalter und der zweite Schalter offen sind. Durch die Referenzspannungseinheit wird erreicht, dass der erste Schalter und der zweite Schalter offen sind, wenn am Eingangsanschluss kein Signal anliegt (d.h. der Eingangsanschluss hochohmig ist).

Erfindungsgemäß umfasst die Ansteuerschaltung Folgendes: einen dritten Schalter, der zwischen dem Eingangsanschluss und dem Steueranschluss des ersten Schalters geschaltet ist, und einen vierten Schalter, der zwischen dem Eingangsanschluss und dem Steueranschluss des zweiten Schalters geschaltet ist. Der dritte Schalter kann bei Anliegen des ersten Pegelniveaus an dem Eingangsanschluss geschlossen sein. Der vierte Schalter kann bei Anliegen des zweiten Pegelniveaus an dem Eingangsanschluss geschlossen sein. Optional umfasst die Referenzspannungseinheit einen Spannungsteiler mit einem dritten Spannungsanschluss und einem vierten Spannungsanschluss, um eine Referenzspannung zum Erreichen des dritten Pegelniveaus zu liefern.

Optional sind der Spannungsteiler, der erste Schalter und der zweite Schalter mit folgenden Spannungen betreibbar: am dritten Spannungsanschluss kann eine Spannung in einem Bereich zwischen 3 V und 5 V anliegen, am vierten Spannungsanschluss und am zweiten Spannungsanschluss ein Massepotential anliegen und an dem ersten Spannungsanschluss eine Spannung von zumindest 5 V (oder 10V, 12V, 20V, 32V, ...) anliegen.

Der erste Schalter und/oder der zweite Schalter und/oder der dritte Schalter und/oder der vierte Schalter sind oder umfassen Bipolartransistoren, wobei der Transistor des ersten Schalters komplementär ist zu dem Transistor des zweiten Schalters und der Transistor des dritten Schalters komplementär ist zu dem Transistor des vierten Schalters. Die Transistoren können Bipolar-Transistoren oder Feldeffekttransistoren (FET) sein.

Der Pegelwandler umfasst folgende Widerstände:
- einen ersten Widerstand zwischen dem Eingangsanschluss (oder dem dritten Schalter) und dem Steueranschluss des ersten Schalters,
- einen zweiten Widerstand zwischen dem Eingangsanschluss (oder dem vierten Schalter) und dem Steueranschluss des zweiten Schalters,
- einen dritten Widerstand zwischen dem Steueranschluss des ersten Schalters und dem ersten Spannungsanschluss,
- einen vierten Widerstand zwischen dem Steueranschluss des zweiten Schalters und dem zweiten Spannungsanschluss,
- einen fünften Widerstand zwischen dem Eingangsanschluss und den Steueranschlüssen des dritten Schalters und/oder des vierten Schalters, und optional:
   - einen sechsten Widerstand zwischen dem dritten Spannungsanschluss und dem Steueranschluss des dritten Schalters, und
   - einen siebten Widerstand zwischen dem vierten Spannungsanschluss und dem Steueranschluss des vierten Schalters.

Außerdem kann der Pegelwandler einen achten Widerstand zwischen dem ersten Schalter und dem zweiten Schalter aufweisen. Ebenso kann der Pegelwandler zwischen dem ersten Schalter und Ausgangsanschluss eine Diode aufweisen, die ausgebildet ist, um einen rückfließenden Strom (d.h. entgegen dem Strom, der beim Schließen des ersten Schalters fließt) zwischen dem Ausgangsanschluss und dem ersten Spannungsanschluss zu verhindern.

Optional kann der zumindest eine Ausgangsanschluss zwei Ausgangsanschlüsse aufweisen, d.h. den einen Ausgangsanschluss und den anderen Ausgangsanschluss umfassen, wobei der erste Schalter und der zweite Schalter ansprechend auf die verschiedenen Pegelniveaus am Eingangsanschluss derart schaltbar sind, dass zumindest einer der Ausgangsanschlüsse hochohmig geschaltet ist.

Die vorliegende Erfindung bezieht sich auch auf ein Steuergerät eines Fahrzeuges, insbesondere eines Nutzfahrzeuges, mit einem der zuvor beschriebenen Pegelwandler. Ebenso bezieht sich die Erfindung auf ein Nutzfahrzeug mit diesem Steuergerät.

Die vorliegende Erfindung bezieht sich außerdem auf ein Verfahren zum Wandeln von Pegelwerten in einem Fahrzeugsteuergerät. Das Verfahren umfasst die Schritte:
- Schalten, durch einen ersten Schalter, eines ersten Strompfades zwischen einem ersten Spannungsanschluss und einem Ausgangsanschluss oder einem der Ausgangsanschlüsse; und
- Schalten, durch einen zweiten Schalter, eines zweiten Strompfades zwischen dem zweiten Spannungsanschluss und dem Ausgangsanschluss oder einem anderen der Ausgangsanschlüsse,
   wobei der erste Schalter und der zweite Schalter ansprechend auf verschiedene Pegelniveaus am Eingangsanschluss derart geschaltet werden, dass
- bei Anliegen eines ersten Pegelniveaus an dem Eingangsanschluss der erste Schalter geschlossen ist und der zweite Schalter geöffnet ist und
- bei Anliegen eines zweiten Pegelniveaus der erste Schalter geöffnet ist und der zweite Schalter geschlossen ist.

Die vorliegende Erfindung bezieht sich auch auf eine Verwendung eines der zuvor beschriebenen Pegelwandler zum Testen eines Steuergerätes, insbesondere zum Feststellen eines Kurzschlusses. Durch die verschiedenen Pegelwerte wird es möglich Kurzschlüsse zu verschiedenen Potentialniveaus feststellen, d.h. ob ein Kurzschluss hin zur Masse oder zur Betriebsspannung vorliegt (z.B. durch Strommessungen).

Ausführungsbeispiele bieten im Vergleich zum Stand der Technik insbesondere die folgenden Vorteile:
- Es wird nur eine Signalleitung (Rechner-PIN) benötigt, um eine 3-Zustands-Pegelwandlung durchzuführen. Dies führt zu einer Einsparung von Rechnerressourcen.
- Der Pegelwandler kann diskrete Bauelemente nutzen, sodass eine Umsetzung auf beliebige Ausgangsspannungen möglich ist.
- Prinzipiell ist es möglich die Pegelwandlung auf beliebige Pegelwerte durchzuführen, insbesondere auch auf Pegelwerte, die höher liegen als die Eingangsspannung.
- Durch eine zyklische Ansteuerung der Schaltung mit drei Eingangspegeln, zum Beispiel LOW (0 V), offen (hochohmig) und HIGH (zum Beispiel 5 V), kann der Pegelwandler zu Testzwecken genutzt werden, wobei die zu testenden Schaltungen mit den entsprechenden Spannungspegeln gezielt angesteuert werden, um festzustellen, zu welchem Potentialniveau ein Kurzschluss besteht.
- Es sind keine Spezialbauelemente erforderlich.
- Es können beispielsweise Überwachungen von Analogsignalen, Endstufen oder Spannungsbegrenzungsschaltungen ohne viel Aufwand umgesetzt werden.

Die Ausführungsbeispiele der vorliegenden Erfindung werden besser verstanden von der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt ein Prinzipschaltbild des Pegelwandlers gemäß einem Ausführungsbeispiel der vorliegenden Erfindung.
- Fig. 2: zeigt ein Ausführungsbeispiel für eine konkrete Umsetzung mittels komplementärer Transistoren als Schalter.
- Fig. 3: zeigt weitere optionale Details des Ausführungsbeispiels aus der Fig. 2.
- Fig. 4: zeigt ein weiteres Ausführungsbeispiel für einen Pegelwandler mit zwei Ausgangsanschlüssen.

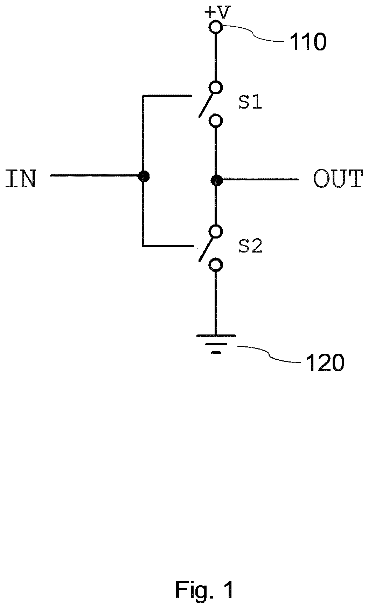

**Fig. 1** zeigt ein Prinzipschaltbild des Pegelwandlers gemäß einem Ausführungsbeispiel der vorliegenden Erfindung. Der Pegelwandler kann beispielsweise für oder in ein(em) Fahrzeugsteuergerät genutzt werden und umfasst: einen ersten Spannungsanschluss 110, einen zweiten Spannungsanschluss 120, einen Ausgangsanschluss OUT, einen Eingangsanschluss IN, einen ersten Schalter 110 und einen zweiten Schalter 120. Der erste Schalter S1 dient zum Schalten eines ersten Strompfades zwischen dem ersten Spannungsanschluss 110 und dem Ausgangsanschluss OUT. Der zweite Schalter S2 dient zum Schalten eines zweiten Strompfades zwischen dem zweiten Spannungsanschluss 120 und dem Ausgangsanschluss OUT. Der erste Schalter S1 und der zweite Schalter S2 sind ansprechend auf verschiedene Pegelniveaus am Eingangsanschluss IN derart schaltbar, dass (i) bei Anliegen eines ersten Pegelniveaus an dem Eingangsanschluss IN der erste Schalter S1 geschlossen ist und der zweite Schalter S2 geöffnet ist, und (ii) bei Anliegen eines zweiten Pegelniveaus der erste Schalter S1 geöffnet ist und der zweite Schalter S2 geschlossen ist.

Das erste Pegelniveau kann beispielsweise eine Hochspannung sein und das zweite Pegelniveau kann beispielsweise eine Niedrigspannung. Außerdem können der erste Schalter S1 und der zweite Schalter S2 so gewählt sein, dass sie bei einem dazwischenliegenden, dritten Pegelniveau offen sind.

Der erste Schalter S1 und der zweite Schalter S2 umfassen weiterhin jeweils einen Steueranschluss, die beide an den Eingangsanschluss IN koppeln. An diesen Steueranschlüssen liegen beispielsweise die genannten Pegelniveaus an, um die gewünschten Schaltoperationen zu bewirken.

Der gezeigte Pegelwandler ist somit in der Lage, durch eine gezielte Ansteuerung des Eingangsanschlusses IN drei Zustände am Ausgangsanschluss OUT umzusetzen. Der erste Zustand ist beispielsweise dadurch gegeben, dass sowohl der erste Schalter S1, als auch der zweite Schalter S2 offen sind, sodass der Ausgangsanschluss OUT hochohmig ist (kein definierter Spannungswert anliegt). Der zweite Zustand kann beispielsweise dadurch erreicht werden, dass der erste Schalter S1 geschlossen wird, der zweite Schalter S2 aber geöffnet bleibt, was durch einen entsprechenden Pegelwert am Eingangsanschluss IN erreicht wird. Dieser zweite Zustand bewirkt, dass am Ausgangsanschluss OUT der Spannungswert +V von dem ersten Spannungsanschluss 110 anliegt. Der dritte Zustand kann erreicht werden, indem der erste Schalter S1 geöffnet wird und der zweite Schalter S2 geschlossen wird, was dazu führt, dass der Pegelwert am Ausgangsanschluss OUT auf die Spannung gesetzt wird, die an dem zweiten Spannungsanschluss 120 anliegt (z.B. Massepotential). Die Spannung V+ am ersten Spannungsanschluss 110 kann beliebig gewählt werden.

Dieses Schaltungsschema kann beispielsweise dadurch erreicht werden, dass die Schalter S1, S2 komplementär zueinander ausgebildet sind, d.h. es gibt immer einen Pegelwert für den der eine Schalter offen und der andere Schalter geschlossen ist, nicht aber beide Schalter gleichzeitig geschlossen sein können. Optional können aber beide Schalter offen sein (zum Beispiel, wenn am Eingangsanschluss IN kein definierter Spannungswert anliegt).

An dem Eingangsanschluss IN kann beispielsweise der eingangs erwähnte Rechnerport (Signalleitung) angeschlossen werden, sodass der Pegelwandler mit dieser einen Signalleitung steuerbar ist.

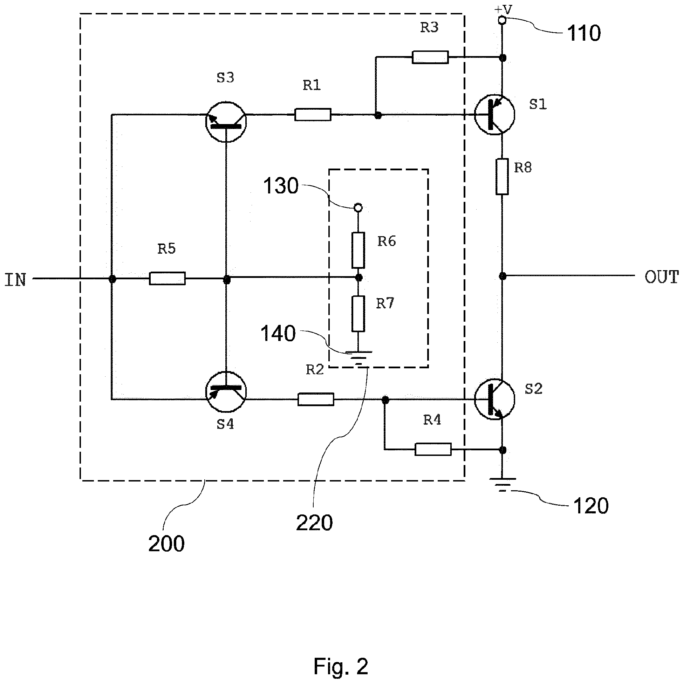

**Fig. 2** zeigt eine mögliche Umsetzung für die genannte komplementäre Schaltungsoperation. Dazu ist der erste Schalter S1 als ein erster Transistor und der zweite Schalter S2 als ein zweiter Transistor ausgebildet, die komplementär zueinander sind. Zum Beispiel kann es sich um Bipolar-Transistoren handeln, wobei der erste Transistor S1 ein pnp- (oder npn-) Transistor ist, während der zweite Transistor S2 entsprechend ein npn- (oder pnp-) Transistor ist. Die gezeigten bipolaren Transistoren können natürlich auch durch Feldeffekttransistoren ersetzt werden.

In dem Ausführungsbeispiel der Fig. 2 umfasst der Pegelwandler weiter eine Ansteuerschaltung 200, die die Ansteuerung des ersten Schalters S1 und des zweiten Schalters S2 übernimmt. Die Ansteuerschaltung 200 umfasst dabei einen Eingang für den Eingangsanschluss IN und zumindest zwei Ausgänge, wovon einer an den Steueranschluss (Basis vom Bipolar-Transistors) des ersten Schalters S1 und ein zweiter an den Steueranschluss (Basis vom Bipolar-Transistors) des zweiten Schalters S2 koppelt.

Außerdem umfasst die Ansteuerschaltung 200 einen dritten Schalter S3 und einen vierten Schalter S4. Der dritte Schalter S3 und der vierte Schalter S4 umfassen jeweils einen Steueranschluss, der elektrisch mit dem Eingangsanschluss IN verbunden ist. Außerdem ist der dritte Schalter S3 zwischen dem Eingangsanschluss IN und dem Steueranschluss des ersten Schalters S1 geschaltet. Der vierte Schalter S4 ist in ähnlicher Weise zwischen dem Eingangsanschluss IN und dem Steueranschluss des zweiten Schalters S2 geschaltet.

Die Ansteuerschaltung 200 umfasst ebenfalls eine Referenzspannungseinheit 220, die einen Spannungswert für den Steueranschluss des dritten Schalters S3 und für den Steueranschluss des vierten Schalters S4 bereitstellt, und zwar für den Fall, wenn am Eingangsanschluss IN kein definierter Pegelwert anliegt. Die Referenzspannungseinheit 220 ist beispielsweise ein Spannungsteiler, der einen dritten Spannungswert (zum Beispiel 3,3 V) auf einen vorbestimmten Spannungswert umsetzt, der so gewählt ist, dass der dritte Schalter S3 und der vierte Schalter S4 bei einem hochohmigen Eingangsanschluss IN beide offen sind und an beiden Steueranschlüssen des ersten und der zweiten Schalters S1, S2 der dritte Pegelwert anliegt, sodass der ersten und der zweiten Schalter geöffnet werden.

Schließlich umfasst der Pegelwandler aus der Fig. 2 insgesamt acht Widerstände, die beispielsweise wie folgt angeordnet sein können. Ein erster Widerstand R1 ist zwischen dem Steueranschluss des ersten Schalters S1 und dem dritten Schalter S3 angeordnet (zum Beispiel an einem Source- oder Drain-Anschluss des beispielhaften Transistors). Ein zweiter Widerstand R2 ist zwischen dem Steueranschluss des zweiten Schalters S2 und dem vierten Schalter S4 angeordnet (zum Beispiel an einem Source- oder Drain-Anschluss des beispielhaften Transistors). Ein dritter Widerstand R3 ist zwischen dem ersten Spannungsanschluss 110 und dem Steueranschluss des ersten Schalters S1 angeordnet. Ein vierter Widerstand R4 ist zwischen dem zweiten Spannungsanschluss 120 und dem Steueranschluss des zweiten Schalters S2 geschaltet. Ein fünfter Widerstand R5 ist zwischen dem Eingangsanschluss IN und den Steueranschlüssen des dritten Schalters S3 bzw. des vierten Schalters S4 geschaltet. Ein sechster Widerstand R6 und ein siebter Widerstand R7 sind Teil des Spannungsteilers in der beispielhaften Referenzspannungseinheit 220 und sind zwischen einem dritten Spannungsanschluss 130 und einem vierten Spannungsanschluss 140 seriell geschaltet, wobei zwischen dem sechsten Widerstand R6 und dem siebten Widerstand R7 Strompfade zu den Steueranschlüssen des dritten Schalters S3 und des vierten Schalters S4 gebildet sind. Zwischen dem ersten Schalter S1 und dem zweiten Schalter S2 ist optional ein achter Widerstand R8 angeordnet (z.B. zwischen dem ersten Schalter S1 und dem Ausgangsanschluss OUT). Der achte Widerstand R8 begrenzt den Strom zwischen dem ersten Spannungsanschluss 110 und dem zweiten Spannungsanschluss 120, z.B. bei einem Umschalten am Eingangsanschluss IN (von LOW auf HIGH oder umgekehrt).

In der Ausführungsform der Fig. 2 sind alle Schalter, d. h. der erste Schalter S1, der zweite Schalter S2, der dritte Schalter S3 und der vierte Schalter S4, beispielhaft durch Transistoren gebildet (bipolar oder Feldeffekttransistoren), wobei nicht nur der erste Transistor S1 komplementär ist zu dem zweiten Transistor S2, sondern auch der dritte Transistor S3 komplementär ist zu dem vierten Transistor S4.

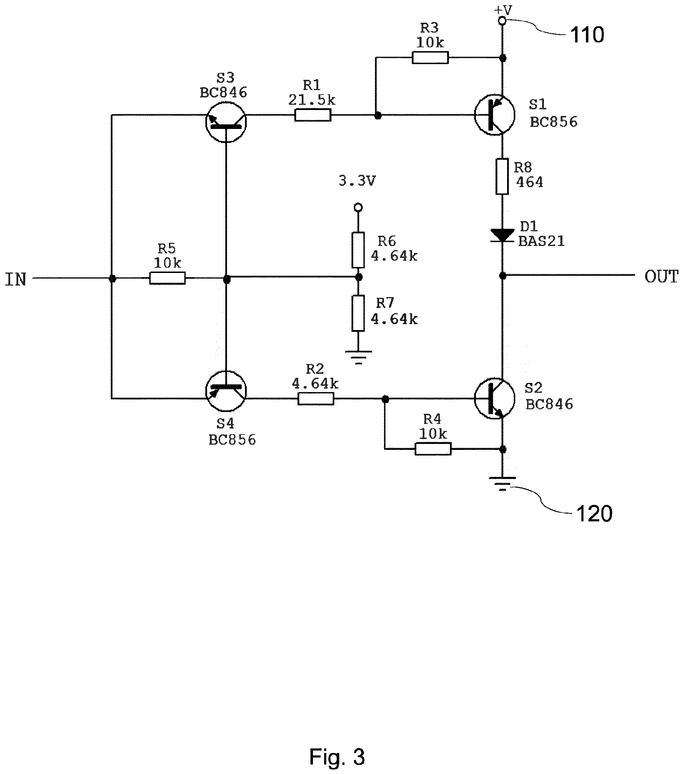

Fig. 3 zeigt ein weiteres Ausführungsbeispiel für den Pegelwandler, wobei sich das Ausführungsbeispiel lediglich dadurch unterscheidet, dass zwischen dem achten Widerstand R8 und dem Ausgangsanschluss OUT eine optionale Diode D1 vorgesehen ist, die verhindert, dass ein Strom von dem Ausgangsanschluss OUT zu dem ersten Spannungsanschluss 110 fließen kann oder diesen Strom zumindest begrenzen soll. Ansonsten sind alle weiteren Elemente in der gleichen Weise ausgebildet wie in der Fig. 2, sodass eine wiederholte Beschreibung nicht erforderlich ist.

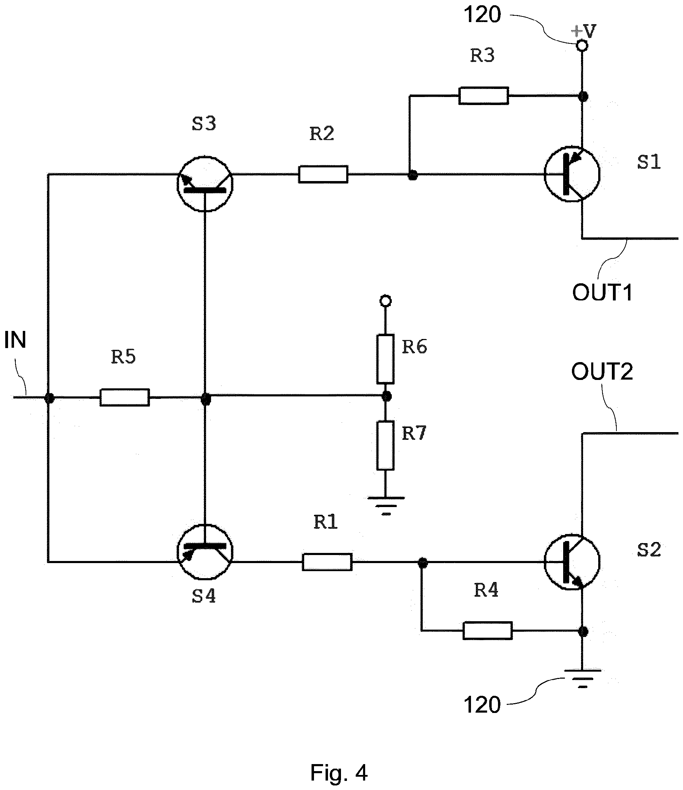

Fig. 4 zeigt ein weiteres Ausführungsbeispiel für einen Pegelwandler mit zwei Ausgangsanschlüssen OUT1, OUT2, wobei der erste Schalter S1 den ersten Strompfad zwischen dem ersten Spannungsanschluss 110 und einem der Ausgangsanschlüsse OUT1 schaltet. Der zweiten Schalter S2 schaltet den zweiten Strompfad zwischen dem zweiten Spannungsanschluss 120 und einem anderen der Ausgangsanschlüsse OUT2. Die Schaltoperationen sind aber wieder derart, dass zumindest einer der Ausgangsanschlüsse OUT1, OUT2 stets hochohmig geschaltet ist. Alle weiteren Elemente sind in der gleich Weise ausgebildet wie in den zuvor beschriebenen Ausführungsbeispielen. Insbesondere kann entlang des ersten Strompfades und/oder entlang des zweiten Strompfades wieder ein achter Widerstand R8 oder einen Diode D1 vorgesehen sein (z.B. zwischen dem ersten/zweiten Schalter S1, S2 und dem entsprechenden Ausgang OUT1/OUT2). Durch ein einfaches Verbinden der beiden Ausgangsanschlüsse OUT1 und OUT2 entstehen die zuvor beschriebenen Konfigurationen.

An der ersten Spannungsquelle 110 kann wie bereits gesagt ein Spannungswert von ca. 5 V anliegen. Es können aber auch höhere Spannungswerte (im Prinzip beliebige Spannungswerte) dort anliegen. So kann beispielsweise ein Spannungswert von ca. 10 V, 20 V oder 32 V dort anliegen. An dem zweiten Spannungsanschluss 120 und an dem vierten Spannungsanschluss 140 liegt beispielsweise eine Referenzspannung (zum Beispiel Masse) an und an dem dritten Spannungsanschluss 130 ein Spannungswert von beispielhaften 3,3 V an. Aufgrund des Spannungsteilers wird der Spannungswert von 3,3 V beispielsweise geteilt auf einen Spannungswert von 1,65 V, was dazu führt, dass, wenn am Eingangsanschluss IN offen ist oder dort ebenfalls ein Spannungswert von ca. 1,65 V anliegt, sowohl der dritte Schalter S3 als auch der vierte Schalter S4 geöffnet sind und somit der Ausgangsanschluss OUT hochohmig ist. In Abhängigkeit der genutzten Transistoren für die Schalter S1, ..., S4 erfolgt die Schaltaktion für bestimmte Pegelwerte. Ein erster Pegelwert kann dadurch definiert werden, dass am Eingangsanschluss ein Spannungswert von 0 V (Masse) bis zu einem ersten oberen Spannungswert (zum Beispiel 1,2 V) anliegt. Zwischen dem ersten Spannungswert und einem zweiten Spannungswert (zum Beispiel 2 V) ist der Ausgangsanschluss OUT hochohmig und oberhalb des zweiten Spannungswertes (zum Beispiel 2 V) ist der Ausgangsanschluss OUT auf Masse gezogen.

Die Widerstände können beispielsweise wie folgt gewählt werden. Der erste Widerstand R1 kann einen Wert von 21,5 kΩ aufweisen, der zweite Widerstand R2 einen Wert von 4,64 kΩ, der dritte, vierte und fünfte Widerstand R3, R4, R5 können Widerstandswerte von jeweils 10 kΩ aufweisen, der sechste und der siebte Widerstand R6, R7 können jeweils einen Wert von 4,64 kΩ aufweisen und der achte Widerstand einen Wert von 464 Ω. Diese Werte sind nur beispielhaft zu verstehen und können bei anderen Ausführungsbeispielen anders gewählt sein.

Die genannten Widerstands- und Spannungswerte verstehen sich lediglich beispielhaft und können auf beliebige andere Werte entsprechend angepasst werden. Insbesondere können alle genannten Werte einen Toleranzbereich von ±3% oder ± 10% oder ± 50% umfassen.

Die entsprechenden Bereiche, in welchen die drei Zustände durch den Pegelwandler angenommen werden, können durch die Widerstände in Abhängigkeit der genutzten Transistoren eingestellt werden. Beispielsweise können am Eingangsanschluss IN Spannungswerte von 0 bis 3,3 V genutzt werden, um die drei gewünschten Zustände zu schalten. Wie gesagt kann in einem Spannungsbereich zwischen 1,2 und 2 V der dritte und der vierte Schalter S3, S4 offen sein, sodass auch der ersten und zweite Schalter S1, S2 offen sind und am Ausgangsanschluss OUT kein definierter Spannungswert anliegt (der Zustand ist offen). Wenn am Eingangsanschluss IN ein Spannungswert von nahe 0 V (Masse) bzw. kleiner von 1,2 V anliegt, kann beispielsweise der dritte Schalter S3 sich schließen und der vierte Schalter S4 (da beide komplementär zueinander sind) sich öffnen, was dazu führt, dass der erste Schalter S1 sich schließt und der zweite Schalter sich öffnet, sodass am Ausgangsanschluss OUT der Spannungswert V+ von dem ersten Spannungsanschluss 110 anliegt. Wenn am Eingangsanschluss IN ein Spannungswert von größer als 2 V oder nahe 3,3 V anliegt, öffnet der dritte Schalter S3 und der vierte Schalter S4 wird geschlossen, was dazu führt, dass der zweite Schalter S2 sich schließt (und der erste Schalter S1 öffnet), was dazu führt, dass am Ausgangsanschluss OUT das Massepotential von der zweiten Spannungsquelle 120 anliegt.

Die genannten Funktionen können auch wie folgt zusammengefasst werden:
1. Wird der Eingangsanschluss IN offengelassen, bzw. ist der Rechnerport auf Input geschaltet, leiten die Schalter S1 bis S4 nicht und der Ausgang OUT ist hochohmig.
2. Wird der Eingangsanschluss IN auf Masse (oder ein Referenzpotential GND oder LOW) gezogen, werden die Schalter S1 und S3 leitend und der Ausgang OUT liegt auf dem ersten Spannungswert +V des ersten Spannungsanschlusses 110 (abzüglich einer Sättigungsspannung des ersten Schalters S1 und der eventuell vorhandenen Diode D1).
3. Wird am Eingangsanschluss IN die Spannung erhöht (z.B. auf HIGH) und wird größer als die Spannung an R6/R7 + 0,8 V, so werden die Schalter S2 und S4 leitend und der Ausgangsanschluss OUT liegt auf der Sättigungsspannung von dem zweiten Schalter S2.

Die Diode D1 dient nur als Kurzschluss-Schutz, falls am Ausgangsanschluss OUT eine höhere Spannung anliegen sollte als an dem ersten Spannungsanschluss 110 (d.h. +V). Der achte Widerstand R8 dient zur Begrenzung eines eventuell vorhandenen Querstromes im Umschaltfall zwischen dem Hochspannungsniveau, dem Niederspannungsniveau am Eingangsanschluss IN.

### BEZUGSZEICHENLISTE

- 110, 120,...: Spannungsanschlüsse
- S1, S2,...: Schalter
- R1, R2,...: Widerstände
- D1: Diode
- IN: Eingangsanschluss
- OUT,OUT1, ...: ein oder mehrere Ausgangsanschlüsse
- 200: Ansteuerschaltung
- 220: Referenzspannungseinheit

## Patentansprüche

1. Tristate-Pegelwandler für ein Fahrzeugsteuergerät, mit folgenden Merkmalen:
- ein erster Spannungsanschluss (110), einen zweiten Spannungsanschluss (120), zumindest einen Ausgangsanschluss (OUT; OUT1, OUT2), einen Eingangsanschluss (IN);
- ein erster Schalter (S1) zum Schalten eines ersten Strompfades zwischen dem ersten Spannungsanschluss (110) und dem zumindest einen Ausgangsanschluss (OUT) oder einem der Ausgangsanschlüsse (OUT1);
- ein zweiter Schalter (S2) zum Schalten eines zweiten Strompfades zwischen dem zweiten Spannungsanschluss (120) und dem zumindest einen Ausgangsanschluss (OUT) oder einem anderen der Ausgangsanschlüsse (OUT2),
wobei der erste Schalter (S1) und der zweite Schalter (S2) ansprechend auf verschiedene Pegelniveaus am Eingangsanschluss (IN) derart schaltbar sind, dass
- bei Anliegen eines ersten Pegelniveaus an dem Eingangsanschluss (IN) der erste Schalter (S1) geschlossen ist und der zweite Schalter (S2) geöffnet ist und
- bei Anliegen eines zweiten Pegelniveaus der erste Schalter (S1) geöffnet ist und der zweite Schalter (S2) geschlossen ist,
wobei der Tristate-Pegelwandler ferner umfasst:
eine Ansteuerschaltung (200) mit einer Referenzspannungseinheit (220) zum Ansteuern der Steueranschlüsse des ersten Schalters (S1) und des zweiten Schalters (S2), wobei der erste Schalter (S1) und der zweite Schalter (S2) jeweils einen Steueranschluss aufweisen, um den ersten Schalter (S1) und den zweiten Schalter (S2) jeweils durch Ansteuersignale zu schalten und bei einem Anliegen eines dritten Pegelniveaus an dem Eingangsanschluss (IN) der erste Schalter (S1) und der zweite Schalter (S2) geöffnet sind, und wobei die Referenzspannungseinheit (220) ausgebildet ist, um das dritte Pegelniveau bereitzustellen, sodass bei einem hochohmig geschalteten Eingangsanschluss (IN) der erste Schalter (S1) und der zweite Schalter (S2) offen sind, wobei der Pegelwandler somit in der Lage ist, durch eine gezielte Ansteuerung des Eingangsanschlusses (IN) drei Zustände am Ausgangsanschluss (OUT; OUT1, OUT2) umzusetzen,
und wobei die Ansteuerschaltung (200) weiter Folgendes umfasst:
- einen dritten Schalter (S3), der zwischen dem Eingangsanschluss (IN) und dem Steueranschluss des ersten Schalters (S1) geschaltet ist; und
- einen vierten Schalter (S4), der zwischen dem Eingangsanschluss (IN) und dem Steueranschluss des zweiten Schalters (S2) geschaltet ist,
wobei der dritte Schalter (S3) bei Anliegen des ersten Pegelniveaus an dem Eingangsanschluss (IN) geschlossen ist und der vierte Schalter (S4) bei Anliegen des zweiten Pegelniveaus an dem Eingangsanschluss (IN) geschlossen ist,
wobei der erste Schalter (S1), der zweite Schalter (S2), der dritte Schalter (S3) und vierte Schalter (S4) Bipolartransistoren sind,
wobei der Pegelwandler einen fünften Widerstand (R5), der zwischen dem Eingangsanschluss (IN) und den Steueranschlüssen des dritten Schalters (S3) und des vierten Schalters (S4) geschaltet ist, und folgende Widerstände aufweist:
- einen ersten Widerstand (R1), der zwischen dem dritten Schalter (S3) und dem Steueranschluss des ersten Schalters (S1) angeordnet ist,
- einen zweiten Widerstand (R2), der zwischen dem vierten Schalter (S4) und dem Steueranschluss des zweiten Schalters (S2) angeordnet ist,
- einen dritten Widerstand (R3), der zwischen dem Steueranschluss des ersten Schalters (S1) und dem ersten Spannungsanschluss (110) angeordnet ist,
- einen vierten Widerstand (R4), der zwischen dem Steueranschluss des zweiten Schalters (S2) und dem zweiten Spannungsanschluss (120) angeordnet ist.

2. Pegelwandler nach Anspruch 1,
**dadurch gekennzeichnet, dass**
das dritte Pegelniveau zwischen dem ersten Pegelniveau und dem zweiten Pegelniveau liegt.

3. Pegelwandler nach einem der vorhergehenden Ansprüche,
**dadurch gekennzeichnet, dass**
die Referenzspannungseinheit (220) einen Spannungsteiler mit einem dritten Spannungsanschluss (130) und einem vierten Spannungsanschluss (140) aufweist, um eine Referenzspannung zum Erreichen des dritten Pegelniveaus zu liefern.

4. Pegelwandler nach Anspruch 3,
**dadurch gekennzeichnet, dass**
der Spannungsteiler, der erste Schalter (S1) und der zweite Schalter (S2) mit folgenden Spannungen betreibbar sind: am dritten Spannungsanschluss (130) eine Spannung in einem Bereich zwischen 3 V und 5 V, am vierten Spannungsanschluss (140) und am zweiten Spannungsanschluss (120) ein Massepotential und an dem ersten Spannungsanschluss (110) eine Spannung von zumindest 5 V.

5. Pegelwandler nach einem der Ansprüche 1 bis 4,
**dadurch gekennzeichnet, dass**
der Transistor des ersten Schalters (S1) komplementär zu dem Transistor des zweiten Schalters (S2) ist und der Transistor des dritten Schalters (S3) komplementär zu dem Transistor des vierten Schalters (S4) ist.

6. Pegelwandler nach einem der Ansprüche 3 bis 5,
**gekennzeichnet durch**
die Vielzahl von Widerständen, die einen oder mehr der folgenden Widerstände aufweisen:
- einen sechsten Widerstand (R6) zwischen dem dritten Spannungsanschluss (130) und dem Steueranschluss des dritten Schalters (S3), und
- einen siebten Widerstand (R7) zwischen dem vierten Spannungsanschluss (140) und dem Steueranschluss des vierten Schalters (S4), wobei der sechste Widerstand (R6) und der siebte Widerstand (R7) seriell zwischen dem dritten Spannungsanschluss (130) und dem vierten Spannungsanschluss (140) geschaltet sind.

7. Pegelwandler nach einem der vorhergehenden Ansprüche,
**gekennzeichnet durch**
ein achter Widerstand (R8) entlang des ersten Strompfades zwischen dem ersten Schalter (S1) und dem zweiten Schalter (S2).

8. Pegelwandler nach einem der vorhergehenden Ansprüche,
**gekennzeichnet durch**
eine Diode (D1) zwischen dem ersten Schalter (S1) und dem zumindest einen Ausgangsanschluss (OUT) oder dem einen der Ausgangsanschlüsse (OUT1), die ausgebildet ist, um einen rückfließenden Strom zwischen dem Ausgangsanschluss (OUT) und dem ersten Spannungsanschluss (110) zu verhindern.

9. Pegelwandler nach einem der vorhergehenden Ansprüche,
**dadurch gekennzeichnet, dass**
der zumindest eine Ausgangsanschluss (OUT1, OUT2) den einen Ausgangsanschluss (OUT1) und den anderen Ausgangsanschluss (OUT2) umfasst, wobei der erste Schalter (S1) und der zweite Schalter (S2) ansprechend auf die verschiedenen Pegelniveaus am Eingangsanschluss (IN) derart schaltbar sind, dass zumindest einer der Ausgangsanschlüsse (OUT1, OUT2) hochohmig geschaltet ist.

10. Steuergerät eines Fahrzeuges, insbesondere eines Nutzfahrzeuges, mit einem Pegelwandler nach einem der Ansprüche 1 bis 9.

11. Nutzfahrzeug mit einem Steuergerät nach Anspruch 10.

12. Verfahren zum Wandeln von Pegelwerten in einem Fahrzeugsteuergerät, mit:
- Schalten, durch einen ersten Schalter (S1), eines ersten Strompfades zwischen einem ersten Spannungsanschluss (110) und zumindest einem Ausgangsanschluss (OUT) oder einem der Ausgangsanschlüsse (OUT1);
- Schalten, durch einen zweiten Schalter (S2), eines zweiten Strompfades zwischen dem zweiten Spannungsanschluss (120) und dem zumindest einen Ausgangsanschluss (OUT) oder einem anderen der Ausgangsanschlüsse (OUT2),
wobei der erste Schalter (S1) und der zweite Schalter (S2) ansprechend auf verschiedene Pegelniveaus am Eingangsanschluss (IN) derart geschaltet werden, dass
- bei Anliegen eines ersten Pegelniveaus an dem Eingangsanschluss (IN) der erste Schalter (S1) geschlossen ist und der zweite Schalter (S2) geöffnet ist und
- bei Anliegen eines zweiten Pegelniveaus der erste Schalter (S1) geöffnet ist und der zweite Schalter (S2) geschlossen ist,
wobei
der erste Schalter (S1) und der zweite Schalter (S2) jeweils einen Steueranschluss aufweisen, um den ersten Schalter (S1) und den zweiten Schalter (S2) jeweils durch Ansteuersignale zu schalten und bei einem Anliegen eines dritten Pegelniveaus an dem Eingangsanschluss (IN) der erste Schalter (S1) und der zweite Schalter (S2) geöffnet sind; und
Ansteuern der Steueranschlüsse des ersten Schalters (S1) und des zweiten Schalters (S2) durch eine Ansteuerschaltung (200) mit einer Referenzspannungseinheit (220), wobei die Referenzspannungseinheit (220) ausgebildet ist, um das dritte Pegelniveau bereitzustellen, sodass bei einem hochohmig geschalteten Eingangsanschluss (IN) der erste Schalter (S1) und der zweite Schalter (S2) offen sind, wobei der Pegelwandler somit in der Lage ist, durch eine gezielte Ansteuerung des Eingangsanschlusses (IN) drei Zustände am Ausgangsanschluss (OUT; OUT1, OUT2) umzusetzen, und wobei die Ansteuerschaltung (200) Folgendes umfasst:
- einen dritten Schalter (S3), der zwischen dem Eingangsanschluss (IN) und dem Steueranschluss des ersten Schalters (S1) geschaltet ist; und
- einen vierten Schalter (S4), der zwischen dem Eingangsanschluss (IN) und dem Steueranschluss des zweiten Schalters (S2) geschaltet ist,
wobei der dritte Schalter (S3) bei Anliegen des ersten Pegelniveaus an dem Eingangsanschluss (IN) geschlossen ist und der vierte Schalter (S4) bei Anliegen des zweiten Pegelniveaus an dem Eingangsanschluss (IN) geschlossen ist,
wobei der erste Schalter (S1), der zweite Schalter (S2), der dritte Schalter (S3) und vierte Schalter (S4) Bipolartransistoren sind,
wobei der Pegelwandler einen fünften Widerstand (R5) zwischen dem Eingangsanschluss (IN) und den Steueranschlüssen des dritten Schalters (S3) und des vierten Schalters (S4) und folgende Widerstände aufweist:
- einen ersten Widerstand (R1), der zwischen dem dritten Schalter (S3) und dem Steueranschluss des ersten Schalters (S1) angeordnet ist,
- einen zweiten Widerstand (R2), der zwischen dem vierten Schalter (S4) und dem Steueranschluss des zweiten Schalters (S2) angeordnet ist,
- einen dritten Widerstand (R3), der zwischen dem Steueranschluss des ersten Schalters (S1) und dem ersten Spannungsanschluss (110) angeordnet ist,
- einen vierten Widerstand (R4), der zwischen dem Steueranschluss des zweiten Schalters (S2) und dem zweiten Spannungsanschluss (120) angeordnet ist.

13. Verfahren zum Testen eines Steuergerätes, um einen Kurzschluss festzustellen, wobei ein Pegelwandler nach einem der Ansprüche 1 bis 9 zum Testen verwendet wird.

## Claims

1. A tristate level converter for a vehicle control device, having the following features:
- a first voltage terminal (110), a second voltage terminal (120), at least one output terminal (OUT; OUT1; OUT2) and an input terminal (IN);
- a first switch (S1) for connecting a first current path between the first voltage terminal (110) and the at least one output terminal (OUT) or one of the output terminals (OUT1); and
- a second switch (S2) for connecting a second current path between the second voltage terminal (120) and the at least one output terminal (OUT) or another of the output terminals (OUT2),
it being possible to connect the first switch (S1) and the second switch (S2) in response to different levels at the input terminal (IN) in such a way that:
- when a first level is present at the input terminal (IN), the first switch (S1) is closed and the second switch (S2) is open, and
- when a second level is present, the first switch (S1) is open and the second switch (S2) is closed,
the tristate level converter further comprising:
a drive circuit (200) having a reference voltage unit (220) for driving the control terminals of the first switch (S1) and of the second switch (S2), the first switch (S1) and the second switch (S2) each having a control terminal for connecting the first switch (S1) and the second switch (S2) by means of drive signals, the first switch (S1) and the second switch (S2) being open when a third level is present at the input terminal (IN), and the reference voltage unit (220) being configured to provide the third level such that the first switch (S1) and the second switch (S2) are open when an input terminal (IN) is switched to high resistance, the level converter thus being capable of converting three states at the output terminal (OUT; OUT1; OUT2) by driving the input terminal (IN) in a targeted manner,
and the drive circuit (200) further comprising the following:
- a third switch (S3) that is connected between the input terminal (IN) and the control terminal of the first switch (S1); and
- a fourth switch (S4) that is connected between the input terminal (IN) and the control terminal of the second switch (S2),
the third switch (S3) being closed when the first level is present at the input terminal (IN), and the fourth switch (S4) being closed when the second level is present at the input terminal (IN),
the first switch (S1), the second switch (S2), the third switch (S3) and the fourth switch (S4) being bipolar transistors,
the level converter having a fifth resistor (R5) that is connected between the input terminal (IN) and the control terminals of the third switch (S3) and of the fourth switch (S4), and the following resistors:
- a first resistor (R1) that is arranged between the third switch (S3) and the control terminal of the first switch (S1),
- a second resistor (R2) that is arranged between the fourth switch (S4) and the control terminal of the second switch (S2),
- a third resistor (R3) that is arranged between the control terminal of the first switch (S1) and the first voltage terminal (110),
- a fourth resistor (R4) that is arranged between the control terminal of the second switch (S2) and the second voltage terminal (120),

2. A level converter according to claim 1,
**characterised in that**
the third level lies between the first level and the second level.

3. A level converter according to either of the preceding claims,
**characterised in that**
the reference voltage unit (220) has a voltage divider with a third voltage terminal (130) and a fourth voltage terminal (140) for supplying a reference voltage in order to achieve the third level.

4. A level converter according to claim 3,
**characterised in that**
the voltage divider, the first switch (S1) and the second switch (S2) can be operated at the following voltages: a voltage in a range of 3 V to 5 V at the third voltage terminal (130), a ground potential at the fourth voltage terminal (140) and at the second voltage terminal (120) and a voltage of at least 5 V at the first voltage terminal (110).

5. A level converter according to any one of claims 1 to 4,
**characterised in that**
the transistor of the first switch (S1) is complementary to the transistor of the second switch (S2), and the transistor of the third switch (S3) is complementary to the transistor of the fourth switch (S4).

6. A level converter according to any one of claims 3 to 5,
**characterised by**
the plurality of resistors that comprises one or more of the following resistors:
- a sixth resistor (R6) between the third voltage terminal (130) and the control terminal of the third switch (S3), and
- a seventh resistor (S7) between the fourth voltage terminal (140) and the control terminal of the fourth switch (S4), the sixth resistor (R6) and the seventh resistor (S7) being connected in series between the third voltage terminal (130) and the fourth voltage terminal (140).

7. A level converter according to any one of the preceding claims,
**characterised by**
an eighth resistor (R8) along the first current path between the first switch (S1) and the second switch (S2).

8. A level converter according to any one of the preceding claims,
**characterised by**
a diode (D1) between the first switch (S1) and the at least one output terminal (OUT) or the output terminal (OUT1) that is configured to prevent a current flowing back between the output terminal (OUT) and the first voltage terminal (110).

9. A level converter according to any one of the preceding claims,
**characterised in that**
the at least one output terminal (OUT1, OUT2) comprises output terminal (OUT1) and output terminal (OUT2), it being possible to connect the first switch (S1) and the second switch (S2) in response to the different levels at the input terminal (IN) in such a way that at least one of the output terminals (OUT1, OUT2) is switched to high resistance.

10. A control device of a vehicle, in particular of a utility vehicle, having a level converter according to any one of claims 1 to 9.

11. A utility vehicle having a control device according to claim 10.

12. A method for converting level values in a vehicle control device, comprising:
- the connection by means of a first switch (S1) of a first current path between a first voltage terminal (110) and at least one output terminal (OUT) or one of the output terminals (OUT1); and
- the connection by means of a second switch (S2) of a second current path between the second voltage terminal (120) and the at least one output terminal (OUT) or another of the output terminals (OUT2),
the first switch (S1) and the second switch (S2) being connected in response to different levels at the input terminal (IN) in such a way that:
- when a first level is present at the input terminal (IN), the first switch (S1) is closed and the second switch (S2) is open and
- when a second level is present, the first switch (S1) is open and the second switch (S2) is closed,
the first switch (S1) and the second switch (S2) each having a control terminal for connecting the first switch (S1) and the second switch (S2) by means of drive signals, and the first switch (S1) and the second switch (S2) being open when a third level is present at the input terminal (IN), and
the driving of the control terminals of the first switch (S1) and of the second switch (S2) by means of a drive terminal (200) having a reference voltage unit (22), the reference voltage unit (220) being configured to provide the third level such that the first switch (S1) and the second switch (S2) are open when an input terminal (IN) is switched to high resistance, the level converter thus being capable of converting three states at the output terminal (OUT; OUT1; OUT2) by driving the input terminal (IN) in a targeted manner, and the drive circuit (200) comprising the following:
- a third switch (S3) that is connected between the input terminal (IN) and the control terminal of the first switch (S1), and
- a fourth switch (S4) that is connected between the input terminal (IN) and the control terminal of the second switch (S2),
the third switch (S3) being closed when the first level is present at the input terminal (IN), and the fourth switch (S4) being closed when the second level is present at the input terminal (IN),
the first switch (S1), the second switch (S2), the third switch (S3) and the fourth switch (S4) being bipolar transistors,
the level converter having a fifth resistor (R5) between the input terminal (IN) and the control terminals of the third switch (S3) and of the fourth switch (S4), and the following resistors:
- a first resistor (R1) that is arranged between the third switch (S3) and the control terminal of the first switch (S1),
- a second resistor (R2) that is arranged between the fourth switch (S4) and the control terminal of the second switch (S2),
- a third resistor (R3) that is arranged between the control terminal of the first switch (S1) and the first voltage terminal (110),
- a fourth resistor (R4) that is arranged between the control terminal of the second switch (S2) and the second voltage terminal (120).

13. A method for testing a control device in order to detect a short circuit using a level converter according to any one of claims 1 to 9.

## Revendications

1. Convertisseur de niveau à trois états d'un appareil de commande de véhicule, ayant les caractéristiques suivantes :
- une première borne (110) de tension, une deuxième borne (120) de tension, au moins une borne (OUT ; OUT1, OUT2) de sortie, une borne (IN) d'entrée ;
- un premier interrupteur (S1) pour l'établissement d'un premier chemin de courant entre la première borne (110) de tension et la au moins une borne (OUT) de sortie ou l'une des bornes (OUT1) de sortie ;
- un deuxième interrupteur (S2) pour l'établissement d'un deuxième chemin de courant entre la deuxième borne (120) de tension et la au moins une borne (OUT) de sortie ou une autre des bornes (OUT2) de sortie,
dans lequel le premier interrupteur (S1) et le deuxième interrupteur (S2) peuvent être connectés à la borne (IN) d'entrée en réaction à divers niveaux, de manière
- à ce que, à l'application d'un premier niveau sur la borne (IN) d'entrée, le premier interrupteur (S1) soit fermé et le deuxième interrupteur (S2) soit ouvert et
- à ce que, à l'application d'un deuxième niveau, le premier interrupteur (S1) soit ouvert et le deuxième interrupteur (S2) soit fermé,
dans lequel le convertisseur de niveau à trois états comprend en outre :
un montage (200) de commande ayant une unité (220) de tension de référence pour la commande des bornes de commande du premier interrupteur (S1) et du deuxième interrupteur (S2), dans lequel le premier interrupteur (S1) et le deuxième interrupteur (S2) ont chacun une borne de commande, afin de connecter le premier interrupteur (S1) et le deuxième interrupteur (S2) respectivement par des signaux de commande et, à l'application d'un troisième niveau à la borne (IN) d'entrée, le premier interrupteur (S1) et le deuxième interrupteur (S2) sont ouverts, et dans lequel l'unité (220) de tension de référence est constituée pour mettre à disposition le troisième niveau de sorte que, si la borne (IN) d'entrée est connectée à grande valeur ohmique, le premier interrupteur (S1) et le deuxième interrupteur (S2) sont ouverts, dans lequel le convertisseur de niveau est ainsi en position, par une commande ciblée de la borne (IN) d'entrée, de passer entre trois états à la borne (OUT ; OUT1, OUT2) de sortie,
et dans lequel le montage (200) de commande comprend ce qui suit :
- un troisième interrupteur (S3), qui est monté entre la borne (IN) d'entrée et la borne de commande du premier interrupteur (S1) ; et
- un quatrième interrupteur (S4), qui est monté entre la borne (IN) d'entrée et la borne de commande du deuxième interrupteur (S2),
dans lequel le troisième interrupteur (S3) est fermé, à l'application du premier niveau à la borne (IN) d'entrée et le quatrième interrupteur (S4) est fermé à l'application du deuxième niveau à la borne (IN) d'entrée,
dans lequel le premier interrupteur (S1), le deuxième interrupteur (S2), le troisième interrupteur (S3) et le quatrième interrupteur (S4) sont des transistors bipolaires,
dans lequel le convertisseur de niveau a une cinquième résistance (R5), qui est montée entre la borne (IN) d'entrée et les bornes de commande du troisième interrupteur (S3) et du quatrième interrupteur (S4) et a les résistances suivantes :
- une première résistance (R1), qui est montée entre le premier interrupteur (S3) et la borne de commande du premier interrupteur (S1),
- une deuxième résistance (R2), qui est montée entre le quatrième interrupteur (S4) et la borne de commande du deuxième interrupteur (S2),
- une troisième résistance (R3), qui est montée entre la borne de commande du premier interrupteur (S1) et la première borne (110) de tension,
- une quatrième résistance (R4), qui est montée entre la borne de commande du deuxième interrupteur (S2) et la deuxième borne (120) de tension.

2. Convertisseur de niveau suivant la revendication 1,
**caractérisé en ce que**
le troisième niveau est entre le premier niveau et le deuxième niveau.

3. Convertisseur de niveau suivant l'une des revendications précédentes,
**caractérisé en ce que**
l'unité (220) de tension de référence a un diviseur de tension ayant une troisième borne (130) de tension et une quatrième borne (140) de tension pour fournir la tension de référence, afin d'atteindre le troisième niveau.

4. Convertisseur de niveau suivant la revendication 3,
**caractérisé en ce que**
le diviseur de tension, le premier interrupteur (S1) et le deuxième interrupteur (S2) peuvent fonctionner avec les tensions suivantes : à la troisième borne (130) de tension, une tension dans une plage comprise entre 3 V et 5 V, à la quatrième borne (140) de tension et à la deuxième borne (120) de tension, un potentiel de masse et à la première borne (110) de tension, une tension d'au moins 5 V.

5. Convertisseur de niveau suivant l'une des revendications 1 à 4,
**caractérisé en ce que**
le transistor du premier interrupteur (S1) est complémentaire du transistor du deuxième interrupteur (S2) et le transistor du troisième interrupteur (S3) est complémentaire du transistor du quatrième interrupteur (S4).

6. Convertisseur de niveau suivant l'une des revendications 3 à 5,
**caractérisé par**
la pluralité de résistances, qui ont une ou plusieurs des résistances suivantes :
- une sixième résistance (R6) entre la troisième borne (130) de tension et la borne de commande du troisième interrupteur (S3), et
- une septième résistance (R7) entre la première borne (140) de tension et la borne de commande du quatrième interrupteur (S4), dans lequel la sixième résistance (R6) et la septième résistance (R7) sont montées en série entre la troisième borne (130) de tension et la quatrième borne (140) de tension.

7. Convertisseur de niveau suivant l'une des revendications précédentes,
**caractérisé par**
une huitième résistance (R8) sur le premier chemin de courant entre le premier interrupteur (S1) et le deuxième interrupteur (S2) .

8. Convertisseur de niveau suivant l'une des revendications précédentes,
**caractérisé par**
une diode (D1) entre le premier interrupteur (S1) et la au moins une borne (OUT) de sortie ou la une des bornes (OUT1) de sortie, qui est constituée pour empêcher un courant de sens inverse entre la borne (OUT) de sortie et la première borne (110) de tension.

9. Convertisseur de niveau suivant l'une des revendications précédentes,
**caractérisé en ce que**
la au moins une borne (OUT1, OUT2) de sortie comprend la une borne (OUT1) de sortie et l'autre borne (OUT2) de sortie, dans lequel le premier interrupteur (S1) et le deuxième interrupteur (S2) peuvent être connectés en réaction aux divers niveaux à la borne (IN) d'entrée, de manière à ce qu'au moins l'une des bornes (OUT1, OUT2) de sortie soit connectée à grande valeur ohmique.

10. Appareil de commande d'un véhicule, en particulier d'un véhicule utilitaire comprenant un convertisseur de niveau suivant l'une des revendications 1 à 9.

11. Véhicule utilitaire comprenant un appareil de commande suivant la revendication 10.

12. Procédé de modification de valeurs de niveau dans un appareil de commande de véhicule, comprenant :
- établissement, par un premier interrupteur (S1), d'un premier chemin de courant entre une première borne (110) de tension et au moins une borne (OUT) de sortie ou l'une des bornes (OUT1) de sortie ;
- établissement, par un deuxième interrupteur (S2), d'un deuxième chemin de courant entre la deuxième borne (120) de tension et la au moins une borne (OUT) de sortie ou une autre des bornes (OUT2) de sortie,
dans lequel on connecte le premier interrupteur (S1) et le deuxième interrupteur (S2) en réaction aux divers niveaux à la borne (IN) d'entrée, de manière
- à ce que, à l'application d'un premier niveau sur la borne (IN) d'entrée, le premier interrupteur (S1) soit fermé et le deuxième interrupteur (S2) soit ouvert et
- à ce que, à l'application d'un deuxième niveau, le premier interrupteur (S1) soit ouvert et le deuxième interrupteur (S2) soit fermé,
dans lequel
le premier interrupteur (S1) et le deuxième interrupteur (S2) ont chacun une borne de commande, afin de connecter le premier interrupteur (S1) et le deuxième interrupteur (S2) chacun par des signaux de commande et, à l'application d'un troisième niveau à la borne (IN) d'entrée, le premier interrupteur (S1) et le deuxième interrupteur (S2) sont ouverts ; et
commande des bornes de commande du premier interrupteur (S1) et du deuxième interrupteur (S2) par un montage (200) de commande ayant une unité (220) de tension de référence, dans lequel l'unité (220) de tension de référence est constituée pour mettre à disposition le troisième niveau de sorte que, pour une borne (IN) d'entrée connectée à grande valeur ohmique, le premier interrupteur (S1) et le deuxième interrupteur (S2) sont ouverts, dans lequel le convertisseur de niveau est en position de faire passer, par une commande ciblée de la borne (IN) d'entrée, entre trois états à la borne (OUT; OUT1, OUT2) de sortie, et dans lequel le montage (200) de commande comprend ce qui suit :
- un troisième interrupteur (S3), qui est monté entre la borne (IN) d'entrée et la borne de commande du premier interrupteur (S1) ; et
- un quatrième interrupteur (S4), qui est monté entre la borne (IN) d'entrée et la borne de commande du deuxième interrupteur (S2),
dans lequel le troisième interrupteur (S3) est fermé, à l'application du premier niveau à la borne (IN) d'entrée et le quatrième interrupteur (S4) est fermé à l'application du deuxième niveau à la borne (IN) d'entrée,
dans lequel le premier interrupteur (S1), le deuxième interrupteur (S2), le troisième interrupteur (S3) et le quatrième interrupteur (S4) sont des transistors bipolaires,
dans lequel le convertisseur de niveau a une cinquième résistance (R5), qui est montée entre la borne (IN) d'entrée et les bornes de commande du troisième interrupteur (S3) et du quatrième interrupteur (S4) et a les résistances suivantes :
- une première résistance (R1), qui est montée entre le premier interrupteur (S3) et la borne de commande du premier interrupteur (S1),
- une deuxième résistance (R2), qui est montée entre le quatrième interrupteur (S4) et la borne de commande du deuxième interrupteur (S2),
- une troisième résistance (R3), qui est montée entre la borne de commande du premier interrupteur (S1) et la première borne (110) de tension,
- une quatrième résistance (R4), qui est montée entre la borne de commande du deuxième interrupteur (S2) et la deuxième borne (120) de tension.

13. Procédé de test d'un appareil de commande pour constater un court-circuit, dans lequel on utilise un convertisseur de niveau suivant l'une des revendications 1 à 9 pour le test.
